# EUROPEAN PATENT APPLICATION

(11) **EP 4 561 279 A1**
(43) Date of publication of application: **28.05.2025**
(21) Application number: 23854289.8
(22) Date of filing: 08.08.2023
(51) Int. Cl.: H05K 7/20

(54) **COOLING SYSTEM**

(30) Priority: 19.08.2022 CN 202210999935
(71) Applicant: Beijing Youzhuju Network Technology Co., Ltd., Beijing 101299 (CN)
(72) Inventor: TIAN, Ting, Beijing 100028 (CN); GUO, Xiaoliang, Beijing 100028 (CN); GAO, Bing, Beijing 100028 (CN); JING, Tangbo, Beijing 100028 (CN); WANG, Jian, Beijing 100028 (CN)
(74) Representative: Dentons UK and Middle East LLP
(86) International application number: PCT/CN2023/111853
(87) International publication number: WO 2024/037386

(57) **Abstract**

Embodiments of the disclosure provide a cooling system, including: a cooling source configured to provide a cooling liquid; an air cooling portion configured to cool an electronic device with a gas, wherein the air cooling portion includes a first liquid inlet and a first liquid outlet, and the first liquid inlet is connected to the cooling source via a first pipeline to receive the cooling liquid from the cooling source; and a liquid cooling portion configured to cool the electronic device with a liquid, wherein the liquid cooling portion includes a second liquid inlet and a second liquid outlet, the second liquid inlet is connected to the first liquid outlet via a second pipeline to receive the cooling liquid from the air cooling portion, and the second liquid outlet is connected to the cooling source via a third pipeline to return the cooling liquid to the cooling source for cooling.

## Description

This application claims priority to Chinese Patent Application No. 202210999935. X, entitled "Cooling System" and filed on Aug. 19, 2022, the entire content of which is incorporated herein by reference.

### FIELD

Embodiments of the present disclosure generally relate to the technical field of electronic device cooling, and more particularly, to a cooling system.

### BACKGROUND

With the integrated development of new generation information communication technologies such as 5G, cloud computing, big data, artificial intelligence and the like and entity economic, a data center is gradually expanding from serving a part of enterprise to serving whole society and becomes a new infrastructure.

The data center usually needs to be planned and designed months or even years in advance, and it is a gradually iterative and clarifying process for the requirements to computing power and network from the actual business requirements of the data center. Therefore, when planning at an early stage, the data center often encounters a problem that the layout and planning of the power density of the data center does not match the power density of server devices that will actually come online in the future. This contradiction is particularly evident when product forms of the server devices are coupled with the data center infrastructure construction. If the power density planned by the data center is too low, it will not be able to accommodate future high power density server device, especially for graphics processing unit (GPU) device, and only a small number of high power density servers can be installed in each cabinet, which will result in a huge waste of rack space. If the power density planned by the data center is too high, it will result in a large amount of HVAC capacity not being effectively utilized, which is a huge waste on the initial investment of the data center.

Therefore, there is a need for an improved data center cooling solution.

### SUMMARY

It is an object of the present disclosure to provide a cooling system to at least partially solve the above problems and other potential problems.

In an aspect of the present disclosure, there is provided a cooling system, including: a cooling source configured to provide a cooling liquid; an air cooling portion configured to cool an electronic device with a gas, wherein the air cooling portion includes a first liquid inlet and a first liquid outlet, and the first liquid inlet is connected to the cooling source via a first pipeline to receive the cooling liquid from the cooling source; and a liquid cooling portion configured to cool the electronic device with a liquid, wherein the liquid cooling portion includes a second liquid inlet and a second liquid outlet, the second liquid inlet is connected to the first liquid outlet via a second pipeline to receive the cooling liquid from the air cooling portion, and the second liquid outlet is connected to the cooling source via a third pipeline to return the cooling liquid to the cooling source for cooling.

In some embodiments, the cooling system further includes a first bypass branch connected between the second pipeline and the third pipeline and configured to guide a portion of the cooling liquid in the second pipeline directly into the third pipeline.

In some embodiments, the first bypass branch includes at least one first valve switchable between an open state and a closed state.

In some embodiments, the cooling source includes a cooling tower including a cooling tower liquid outlet and a cooling tower liquid return port, wherein the cooling tower liquid outlet is connected to the first liquid inlet via the first pipeline, and a dry cooler including a dry cooler liquid outlet and a dry cooler liquid return port, wherein the dry cooler liquid return port is connected to the second liquid outlet via the third pipeline, and the dry cooler liquid outlet is connected to the cooling tower liquid return port via a fourth pipeline.

In some embodiments, the cooling system further includes a second bypass branch connected between the fourth pipeline and the first pipeline and configured to guide at least a portion of the cooling liquid in the fourth pipeline directly into the first pipeline.

In some embodiments, the second bypass branch includes at least one second valve switchable between an open state and a closed state.

In some embodiments, the first liquid outlet is further connected to the cooling tower liquid return port via a pipeline, the second liquid inlet is further connected to the dry cooler liquid outlet via a pipeline, the second pipeline is provided with at least one third valve switchable between an open state and a closed state, and the fourth pipeline is provided with at least one fourth valve switchable between an open state and a closed state.

In some embodiments, the cooling source includes a cooling tower, the cooling tower includes a cooling tower liquid outlet and a cooling tower liquid return port, the cooling tower liquid outlet is connected to the first liquid inlet via the first pipeline, and the cooling tower liquid return port is connected to the second liquid outlet via the third pipeline.

In some embodiments, the air cooling portion includes: a first air cooling portion configured to cool a first portion of the electronic device, wherein the first air cooling portion is provided with the first liquid inlet and the first liquid outlet; and a second air cooling portion configured to cool a second portion of the electronic device, wherein the second air cooling portion is provided with the first liquid inlet and the first liquid outlet, and the second portion of the electronic device is further cooled by the liquid cooling portion.

In some embodiments, the first air cooling portion includes a first air wall configured to draw gas from the first portion of the electronic device, and the second air cooling portion includes a second air wall configured to draw gas from the second portion of the electronic device.

In some embodiments, the liquid cooling portion further includes: a cooling distribution unit including a first cooling liquid circulation path and a second cooling liquid circulation path which exchange heat with each other, wherein the first cooling liquid circulation path is connected to the second liquid inlet and the second liquid outlet to enable the cooling liquid to flow in the first cooling liquid circulation path, and the second cooling liquid circulation path is connected to the electronic device via a circulation pipeline to provide another cooling liquid in the second cooling liquid circulation path to the electronic device.

In some embodiments, the cooling source further includes at least one of a water-cooled screw chiller and a water chiller.

According to the embodiments of the disclosure, by means of temperature step and cooling sources integration and the like, it can be realized that a high-adaptability data center solution of air cooling to liquid cooling switching, or even air cooling and liquid cooling mixed distribution under the same data center infrastructure architecture. This solution can significantly reduce the uncertainty of the data center in the early planning process, meanwhile, due to the utilization of a temperature gradient and integrating external cooling sources and the like, this high-adaptability solution enables the data center to perform well in energy saving and water saving in various forms. In addition, the embodiments of the present disclosure can significantly reduce the PUE and the WUE of the data center while having the advantages of flexible deployment and high adaptability and the like. The liquid cooling technology and the air cooling solution are organically combined, so that the advantages of liquid cooling can be exerted to a great extent to adapt to rapid deployment of the data center.

It should be understood that the content described in this content section is not intended to limit the key features or important features of the embodiments of the present disclosure, nor is it intended to limit the scope of the present disclosure. Other features of the present disclosure will become readily understood from the following description.

### BRIEF DESCRIPTION OF THE DRAWINGS

The above and other features, advantages, and aspects of various embodiments of the present disclosure will become more apparent from the following detailed description taken in conjunction with the accompanying drawings. In the drawings, the same or similar reference numbers refer to the same or similar elements, wherein:
FIG. 1 to FIG. 3 show schematic structural diagrams of a conventional cooling system;
FIG. 4 to FIG. 8 show schematic structural diagrams of a cooling system according to some embodiments of the present disclosure.

### DETAILED DESCRIPTION

Preferred embodiments of the present disclosure will be described in more detail below with reference to the accompanying drawings. While the preferred embodiments of the present disclosure are shown in the drawings, it should be understood that the present disclosure may be implemented in various forms and should not be limited by the embodiments set forth herein. Rather, these embodiments are provided to make this disclosure more thorough and complete, and to fully convey the scope of the present disclosure to those skilled in the art.

As used herein, the term "comprising" and variations thereof represent openness, i.e., "including but not limited to". Unless specifically stated, the term "or" means "and / or". The term "based on" means "based at least in part on". The terms "an example embodiment" and "an embodiment" mean "at least one example embodiment". The term "another embodiment" means "at least one further embodiment". The terms "first," "second," and the like may refer to different or identical objects.

With the continuous increase of chip power density, the power density of a single cabinet of the generalpurpose server will continue to increase. When the power density of the single cabinet exceeds a certain limit, for example, more than 10 kW -15 kW, the cooling capacity of the room level air conditioning system of the data center will be challenged, and at this time, the heat dissipation requirement of the server device is often met by means of proximal refrigeration or some special means, which directly affects the planning and design of the equipment room.

According to the air cooling heat dissipation solution, the air conditioning system provides cooling energy, the built-in fan of the server draws cold air and discharges hot air after heat exchange, so that the hot air is emitted into the data center room and taken away by the room level air conditioning system. Conventional air cooling heat dissipation solutions are increasingly unable to meet the requirements of data center in terms of cooling capacity and economic feasibility due to low heat dissipation efficiency and a large amount of energy consumption. The liquid cooling heat dissipation solution gradually becomes an important technical direction for data center construction due to the advantages of two aspects of improving the power density of the data center and reducing energy consumption. In the liquid cooling heat dissipation solution, the high power density IT device often uses the cold plate liquid cooling technology to reduce the power usage efficiency (PUE) and water usage effectiveness (WUE) of the data center, and meanwhile reduce the burden on the air cooling side of the data center.

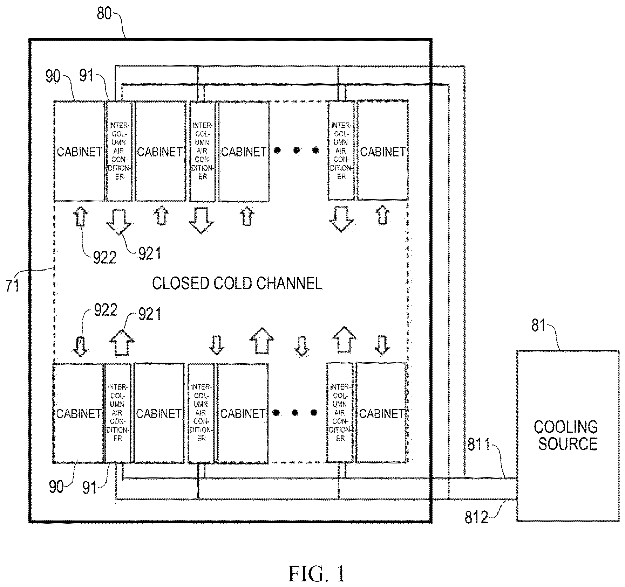

FIG. 1 shows a schematic structural diagram of a conventional cooling system. As shown in FIG. 1, the cooling system uses an air cooling heat dissipation solution to cool electronic devices (for example, server devices) in cabinets 90. The cooling system includes a cooling source 81 disposed outside a room cold pool 80 and a plurality of inter-column air conditioners 91 disposed in the room cold pool 80. The inter-column air conditioners 91 are disposed side by side with the cabinets 90 and are configured to provide cooling energy for the cabinets 90. The inter-column air conditioners 91 need to provide sufficient cooling energy for the power density of the cabinets 90, and how many cabinets 90 need to be provided with one inter-column air conditioner 91 therein is determined by the cooling energy required by the cabinets 90. The cooling source 81 is connected to the inter-column air conditioners 91 via a liquid outlet pipe 811 and a liquid return pipe 812. The cooling source 81 may provide the cooling liquid to each of the inter-column air conditioners 91 via the liquid outlet pipe 811, and the cooling liquid may return to the cooling source 81 for cooling via the liquid return pipe 812 after absorbing heat and warming up in the inter-column air conditioners 91. In this way, the cooling liquid may circulate between the cooling source 81 and the inter-column air conditioners 91.

In some embodiments, as shown in FIG. 1, a closed cold channel 71 may be formed in the room cold pool 80, thereby preventing cold air and hot air mixing to cause cooling energy loss. During operation, the inter-column air conditioners 91 may draw the air in the room cold pool 80 and cool the drawn air to form cold air, and the cold air may be discharged into the closed cold channel 71 along the direction indicated by the first arrow 921. The cold air in the closed cold channel 71 may be blown to each of the cabinets 90 in the direction indicated by the second arrow 922, thereby cooling the server devices in the cabinets 90. The advantage of this air cooling solution is that the inter-column air conditioners 91 are in proximity to the cabinets 90, which is proximal refrigeration, resulting in higher cooling efficiency. In some cases, the inter-column air conditioners 91 and the server devices may even achieve cabinet-level integrated, which effectively improves the air cooling efficiency.

It should be understood that, in some embodiments, instead of the closed cold channel 71 shown in FIG. 1, a closed hot channel may be formed in the room cold pool 80 to prevent cold air and hot air mixing to cause cooling energy loss. In addition, in some embodiments, the inter-column air conditioners 91 may be disposed at other positions relative to the cabinets 90, for example, on the top of the cabinets or the bottom of the equipment room.

In some embodiments, the cooling source 81 may include at least one of a cooling tower, a dry cooler, a water-cooled screw chiller, or a water chiller.

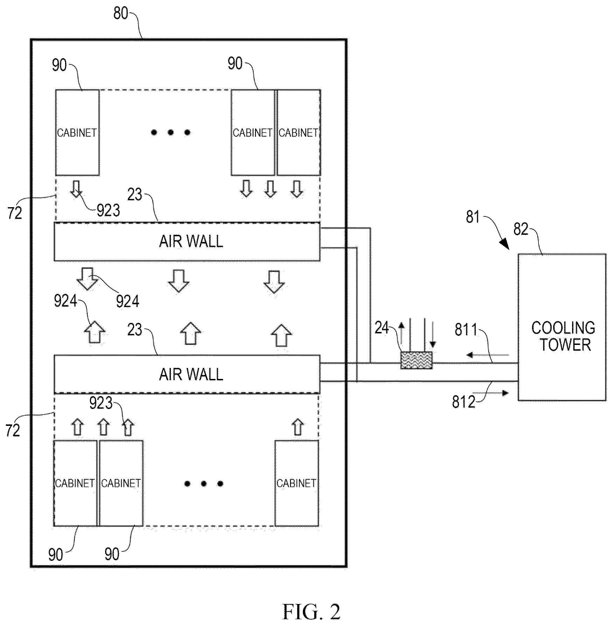

FIG. 2 shows a schematic structural diagram of a conventional cooling system. As shown in FIG. 2, the cooling system also uses an air cooling heat dissipation solution to cool electronic devices (for example, server devices) in the cabinets 90. The cooling system includes a cooling source 81 disposed outside the room cold pool 80 and two air walls 23 disposed in the room cold pool 80. The cooling source 81 is connected to each of the air walls 23 via a liquid outlet pipe 811 and a liquid return pipe 812. Each of the air walls 23 may be provided with a heat dissipation pipe communicating with the liquid outlet pipe 811 and the liquid return pipe 812, so that the cooling liquid may flow into the heat dissipation pipe from the liquid outlet pipe 811 and flow into the liquid return pipe 812 from the heat dissipation pipe. The air walls 23 may also be provided with fans for driving air in the cabinets 9 to flow to the air walls 23 in the direction indicated by the third arrow 923, so that the hot air from the cabinets 9 is cooled by the heat dissipation pipes in the air walls 23, and the cooled air is discharged into the room cold pool 80 in the direction indicated by the fourth arrow 924. In this process, the cooling liquid in the heat dissipation pipes of the air walls 23 is heated due to heat absorption, and the heated cooling liquid can flow back to the cooling source 81 via the liquid return pipe 812, and can be cooled again by the external cooling water in the cooling source 81 to perform the next cycle. This air cooling solution has the advantages that the air walls 23 are in proximity to the cabinets 90, which is proximal refrigeration, resulting in higher cooling efficiency.

In some embodiments, as shown in FIG. 2, the cooling source 81 includes a cooling tower 82. The cooling tower 82 may use the sprayed cooling water to cool the cooling liquid in the cooling tower 82. Alternatively or additionally, the cooling source 81 may include at least one of a dry cooler, a water-cooled screw chiller, or a water chiller.

In some embodiments, as shown in FIG. 2, in order to promote the driving of the fans in the air walls 23 to the gas in the cabinets 90, closed hot channels 72 may be formed between the cabinets 90 and the air walls 23, so that the gas from the cabinets 90 may be guided into the air walls 23 through the closed hot channels 72, and to prevent cold air and hot air mixing to cause cooling energy loss.

In some embodiments, as shown in FIG. 2, depending on weather and region, among other things, the cooling system further includes a supplementary cooling equipment 24. The supplementary cooling equipment 24 is disposed in the liquid outlet pipe 811 and is configured to provide an additional cooling energy to the heat dissipation pipes of the air walls 23. The cooling capacity of the air walls 23 can be further improved by means of the supplementary cooling equipment 24.

It should be understood that, in some embodiments, instead of the closed hot channels 72 shown in FIG. 2, closed cold channels may be formed in the room cold pool 80 to prevent cold air and hot air mixing to cause cooling energy loss.

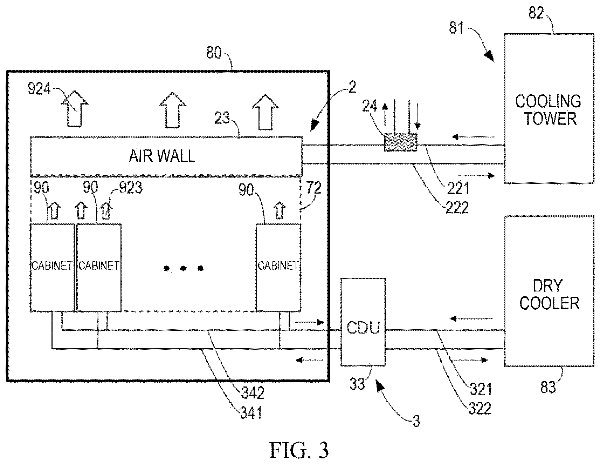

FIG. 3 shows a schematic structural diagram of a conventional cooling system. As shown in FIG. 3, the cooling system generally includes a cooling source 81, an air cooling portion 2, and a liquid cooling portion 3. The liquid cooling portion 3 is configured to take away heat of key components such as central processing units (CPU) and graphics processing units (GPU) and the like in the cabinets 90, and the air cooling portion 2 is configured to take away heat of other components in the cabinets 90.

In some embodiments, as shown in FIG. 3, the cooling source 81 includes a cooling tower 82 and a dry cooler 83. The cooling tower 82 may use the sprayed cooling water to cool the cooling liquid in the cooling tower 82. The cooling tower 82 may be connected to the air cooling portion 2 via a first liquid outlet pipe 221 and a first liquid return pipe 222. The cooling liquid cooled by the external cooling water in the cooling tower 82 may flow into the air cooling portion 2 via the first liquid outlet pipe 221, and the heated cooling liquid circulating in the air cooling portion 2 may return to the cooling tower 82 via the first liquid return pipe 222 and be cooled again by the cooling tower 82. The dry cooler 83 may use external air to cool the cooling liquid therein. The dry cooler 82 may be connected to the liquid cooling portion 3 via a second liquid outlet pipe 321 and a second liquid return pipe 322. The cooling liquid cooled by the external gas in the dry cooler 83 may flow into the liquid cooling portion 3 via the second liquid outlet pipe 321, and the heated cooling liquid circulating in the liquid cooling portion 3 may return to the dry cooler 83 via the second liquid return pipe 322, and be cooled again by the dry cooler 83.

In some embodiments, as shown in FIG. 3, the air cooling portion 2 includes an air wall 23 disposed in the room cold pool 80. The air wall 23 may be provided with a heat dissipation pipe communicating with the first liquid outlet pipe 221 and the first liquid return pipe 222, so that the cooling liquid may flow into the heat dissipation pipe from the first liquid outlet pipe 221 and flow into the first liquid return pipe 222 from the heat dissipation pipe. The air wall 23 may also be provided with a fan for driving air in the cabinets 90 to flow to the air wall 23 in the direction indicated by the third arrow 923, so that the hot air from the cabinets 90 can be cooled by the heat dissipation pipe in the air wall 23, and the cooled air can be discharged into the room cold pool 80 in the direction indicated by the fourth arrow 924. In this process, the cooling liquid in the heat dissipation pipe of the air wall 23 is heated due to heat absorption, and the heated cooling liquid can flow back to the cooling tower 82 via the first liquid return pipe 222, and can be cooled again by the external cooling water in the cooling tower 82 to perform the next cycle.

In some embodiments, as shown in FIG. 3, in order to promote the driving of the fan in the air wall 23 to the gas in the cabinets 90, a closed hot channel 72 may be formed between the cabinets 90 and the air wall 23, so that the gas from the cabinets 90 may be guided into the air wall 23 through the closed hot channel 72, and to prevent cold air and hot air mixing to cause cooling energy loss.

It should be understood that in embodiments according to the present disclosure, the air wall 23 is merely exemplary, and other types of gas driving equipment or arrangements are possible. For example, in some embodiments, the air cooling portion 2 may include inter-column air conditioners disposed next to each of the cabinets 90, and the inter-column air conditioners are connected to the first liquid outlet pipe 221 and the first liquid return pipe 222. The inter-column air conditioners may blow air to the inside of the cabinets 90 laterally, thereby removing heat from the components inside the cabinets 90.

In some embodiments, as shown in FIG. 3, depending on weather and region, among other things, the first liquid outlet pipe 221 may further be provided with a supplementary cooling equipment 24 for providing an additional cooling energy to the circulation pipe of the air cooling portion 2. The cooling capacity of the air cooling portion 2 can be further improved by means of the supplementary cooling equipment 24.

In some embodiments, as shown in FIG. 3, the liquid cooling portion 3 includes a cooling distribution unit (CDU) 33. The cooling distribution unit 33 is connected to the dry cooler 83 via the second liquid outlet pipe 321 and the second liquid return pipe 322, and is connected to the cabinets 90 via the third liquid outlet pipe 341 and the third liquid return pipe 342, so as to distribute and manage the cooling energy provided to the cabinets 90. The third liquid outlet pipe 341 and the third liquid return pipe 342 are connected to cold plates disposed in the cabinets 90 for cooling key components such as CPUs and GPUs and the like. The water supply temperature of the cold plates can be as high as 45 - 50°C, and the return water temperature can be as high as 60°C, so naturally cooling can be achieved all year round in most regions. The cooling distribution unit 33 may provide the cooling liquid to the cold plates via the third liquid outlet pipe 341, and the cooling liquid heated in the cold plates may return to the cooling distribution unit 33 via the third liquid return pipe 342. The cooling distribution unit 33 may include a plate heat exchanger, the plate heat exchanger is connected to the second liquid outlet pipe 321 and the second liquid return pipe 322 to form a first cooling liquid circulation path, and the plate heat exchanger is connected to the third liquid outlet pipe 341 and the third liquid return pipe 342 to form a second cooling liquid circulation path. The cooling liquid in the two circulation paths may exchange heat through the plate heat exchanger.

In some embodiments, the second circulation pipeline 32 may be directly connected to cold plates in the cabinets 90, so as to directly provide the cooling liquid to key components such as CPUs and GPUs and the like without need for heat exchange of the cooling liquid in the two circulation paths through the cooling distribution unit 33. In some other embodiments, the liquid cooling portion 3 may include a plurality of cooling distribution units 33 and a plurality of cooling liquid circulation paths so as to perform a greater number of heat exchange, which is not limited by the embodiments of the present disclosure.

The air-cooled cooling system shown in FIG. 1 and FIG. 2 is easy to cool the high power density cabinet, however, since the heat exchange efficiency of the air cooling heat dissipation solution is lower, the temperature of the cooling medium required by the air-cooled cooling system is generally lower. In order to prepare these low-temperature cooling mediums, the required energy consumption is higher, so that the water consumption of the outdoor unit is larger. In addition, the data center needs to consider the form of proximal refrigeration, the layout of power density and the like when designing and planning at the early stage. However, later adjustments and modifications tend to be relatively difficult after the power and HVAC solutions are determined.

As shown in FIG. 3, the cooling system can directly introduce the cooling medium into the surface of the server devices for heat dissipation, so that the heat dissipation efficiency is high, and thus a cooling medium with a higher temperature can be used. The outdoor cooling source device may be a relatively energy-saving device such as a dry cooler, etc. However, if the data center is planned according to the traditional cold plate liquid cooling data center solution, two sets of cooling source systems need to be designed, and the flexibility of adjusting the air cooling heat dissipation solution matched with the cold plate is also smaller. If the data center is planned according to the cold plate liquid cooling architecture, only the cold plate server device can be carried, and if it needs to be switched to the air cooling heat dissipation solution at a later stage, the problem of insufficient HVAC cooling capacity on the air cooling side can be easily caused.

When the high power density server device is still in the development process, the heat dissipation architecture of the server device may adopt an air cooling heat dissipation solution or a liquid cooling heat dissipation solution, or even the same model may adopt a heat dissipation solution of air cooling and liquid cooling coexistence within a certain period, which may increase the uncertainty in the pre-planning and design of the data center. Therefore, how to design an infrastructure heat dissipation solution with high adaptability is crucial for data centers.

The embodiments of the present disclosure are intended to at least partially solve the above problems, by means of temperature step and cooling source integration and the like, a high-adaptability data center solution of air cooling to liquid cooling switching, or even air cooling and liquid cooling mixed distribution under the same data center infrastructure architecture can be achieved. This solution can significantly reduce the uncertainty of the data center in the early planning process, meanwhile, due to the utilization of a temperature gradient and integrating external cooling sources and the like, this high-adaptability solution enables the data center to perform well in energy saving and water saving in various forms. In addition, the embodiments of the present disclosure can significantly reduce the PUE and the WUE of the data center while having the advantages of flexible deployment and high adaptability and the like. The liquid cooling technology and the air cooling solution are organically combined, so that the advantages of liquid cooling can be exerted to a great extent to adapt to rapid deployment of the data center.

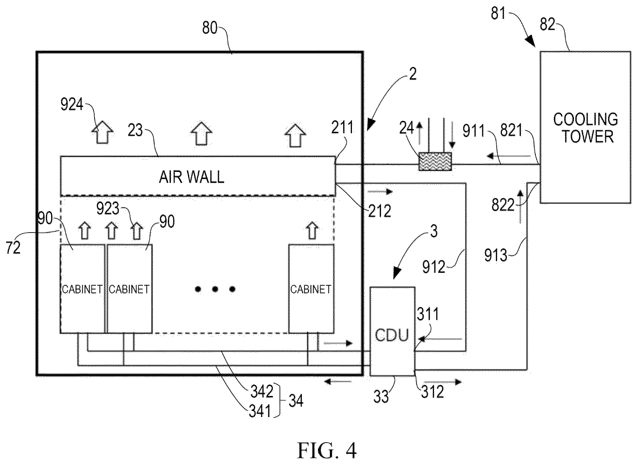

FIG. 4 to FIG. 8 are schematic structural diagrams of cooling systems according to some embodiments of the present disclosure. The principle of the present disclosure will be described in detail below with reference to FIG. 4 to FIG. 8.

In some embodiments, as shown in FIG. 4, a cooling system includes a cooling source 81, an air cooling portion 2, and a liquid cooling portion 3. The cooling source 81 may provide a cooling liquid, such as cooling water or other types of cooling liquid, to the air cooling portion 2 and the liquid cooling portion 3. The air cooling portion 2 may use gas to cool electronic devices (e.g., server devices) in the cabinets 90. The liquid cooling portion 3 may use liquid to cool key electronic devices (e.g., CPUs and GPUs) in the cabinets 90. The air cooling portion 2 includes a first liquid inlet 211 and a first liquid outlet 212. The first liquid inlet 211 is connected to the cooling source 81 via a first pipeline 911 to receive the cooling liquid from the cooling source 81. The liquid cooling portion 3 includes a second liquid inlet 311 and a second liquid outlet 312. The second liquid inlet 311 is connected to the first liquid outlet 212 via a second pipeline 912 to receive the cooling liquid from the air cooling portion 2. The second liquid outlet 312 is connected to the cooling source 81 via a third pipeline 913 to return the cooling liquid to the cooling source 81 for cooling.

With the arrangement described above, the cooling liquid in the cooling source 81 may be provided to the air cooling portion 2 via the first pipeline 911 and the first liquid inlet 211. The cooling liquid heated in the air cooling portion 2 may flow out from the first liquid outlet 212, and flow into the liquid cooling portion 3 via the second pipeline 912 and the second liquid inlet 311. The cooling liquid further heated in the liquid cooling portion 3 may flow out from the second liquid outlet 312 and flow back to the cooling source 81 for cooling via the third pipeline 913. In this way, the cooling liquid may circulate among the cooling source 81, the air cooling portion 2 and the liquid cooling portion 3.

The indoor temperature of the data center generally needs to be controlled to a lower temperature, for example, a typical data center generally requires the indoor temperature in the range of 25°C to 27°C. The air cooling portion 2 has a lower heat dissipation efficiency due to the heat exchange between the indoor hot air and the cooling liquid provided by the cooling source 81. To this end, the air cooling portion 2 requires a lower cooling liquid temperature, depending on the design of the air cooling portion 2, the liquid inlet temperature of the cooling liquid generally needs to be below 25°C. The liquid cooling portion 3 may directly transmit the cooling liquid to the surface of the electronic devices, for example, the surface of the chips, and the surface temperatures of the chips generally reach above 70°C, so the liquid inlet temperature of the liquid cooling portion 3 may reach above 40°C or even up to 50°C. Therefore, the liquid inlet temperature of the liquid cooling portion 3 is generally much higher than the liquid inlet temperature of the air cooling portion 2. According to the embodiment of the present disclosure, the temperature gradient existing between the liquid inlet temperature of the air cooling portion 2 and the liquid inlet temperature of the liquid cooling portion 3 is fully utilized, and pipelines of the air cooling portion 2 and the liquid cooling portion 3 are connected in series, so that the cooling liquid heated in the air cooling portion 2 can be injected into the liquid cooling portion 3 to be heated again. In this way, a data center adopting a pure air cooling heat dissipation solution can be compatibly designed as a data center with a mixed arrangement of air cooling and liquid cooling. In addition, after the mixed arrangement solution is used, a small flow and a large temperature difference design can be adopted, so that after the cooling liquid passes through the air cooling portion 2 and the liquid cooling portion 3, the temperature of the cooling liquid is significantly increased, thereby improving the heat dissipation efficiency of the cooling source 81 and reduces the PUE and the WUE.

In an embodiment, as shown in FIG. 4, the cooling source 81 includes a cooling tower 82. The cooling tower 82 may use the sprayed cooling water to cool the cooling liquid in the cooling tower 82. The cooling tower 82 includes a cooling tower liquid outlet 821 and a cooling tower liquid return port 822. The cooling tower liquid outlet 821 is connected to the first liquid inlet 211 via the first pipeline 911 to provide the cooling liquid to the air cooling portion 2. The cooling tower liquid return port 822 is connected to the second liquid outlet 312 via the third pipeline 913 to receive the returned cooling liquid from the liquid cooling portion 3. Alternatively or additionally, the cooling source 81 may have other types, such as at least one of a dry cooler, a water-cooled screw chiller, or a water chiller.

In one embodiment, as shown in FIG. 4, the air cooling portion 2 includes an air wall 23 disposed in the room cold pool 80. The air wall 23 may be provided with a heat dissipation pipe communicating with the first pipeline 911 and the second pipeline 912, so that the cooling liquid from the cooling source 81 may flow into the heat dissipation pipe from the first pipeline 911 and flow into the second pipeline 912 from the heat dissipation pipe. The air wall 23 may also be provided with a fan for driving air in the cabinets 90 to flow to the air wall 23 in the direction indicated by the third arrow 923, so that the hot air from the cabinets 90 is cooled by the heat dissipation pipe in the air wall 23, and the cooled air is discharged into the room cold pool 80 in the direction indicated by the fourth arrow 924. In this process, the cooling liquid in the heat dissipation pipe of the air wall 23 is heated due to heat absorption, and the heated cooling liquid may flow into the liquid cooling portion 3 via the second pipeline 912.

In some embodiments, as shown in FIG. 4, in order to promote the driving of the fan in the air wall 23 to the gas in the cabinets 90, a closed hot channel 72 may be formed between the cabinets 90 and the air wall 23, so that the gas from the cabinets 90 may be guided into the air wall 23 through the closed hot channel 72, and to prevent cold air and hot air mixing to cause cooling energy loss.

It should be understood that in embodiments according to the present disclosure, the air wall 23 is merely exemplary, and other types of gas driving devices or arrangements are possible. For example, in some embodiments, the air cooling portion 2 may include inter-column air conditioners (such as the inter-column air conditioners 91 shown in FIG. 1) disposed next to each of the cabinets 90, and the inter-column air conditioners are connected to the first pipeline 911 and the second pipeline 912. The inter-column air conditioners may blow air to the inside of the cabinets 90 laterally, thereby removing heat from the components inside the cabinets 90.

In some embodiments, as shown in FIG. 4, depending on weather and region, among other things, the first pipeline 911 may further be provided with a supplementary cooling equipment 24 for providing additional cooling energy to the circulation pipeline of the air cooling portion 2. The cooling capacity of the air cooling portion 2 can be further improved by means of the supplementary cooling equipment 24.

In some embodiments, as shown in FIG. 4, the liquid cooling portion 3 includes a cooling distribution unit 33, and the cooling distribution unit 33 is provided with a second liquid inlet 311 and a second liquid outlet 312 as described above. The cooling distribution unit 33 is connected to the second pipeline 912 and the third pipeline 913, and is connected to the cabinets 90 via the circulation pipeline 34, so as to distribute and manage the cooling energy provided to the cabinets 90. The circulation line 34 includes a third liquid outlet pipe 341 and a third liquid return pipe 342 which are connected to cold plates disposed in the cabinets 90 for cooling key components such as CPUs and GPUs and the like.

The cooling distribution unit 33 may provide another cooling liquid to the cold plates via the third liquid outlet pipe 341, and the cooling liquid heated in the cold plates may return to the cooling distribution unit 33 via the third liquid return pipe 342. The cooling distribution unit 33 may include a plate heat exchanger, the plate heat exchanger is connected to the second pipeline 912 and the third pipeline 913 to form a first cooling liquid circulation path, and the plate heat exchanger is connected to the third liquid outlet pipe 341 and the third liquid return pipe 342 to form a second cooling liquid circulation path. The cooling liquid in the two circulation paths may exchange heat through the plate heat exchanger.

In some embodiments, the second pipeline 912 and the third pipeline 913 may be directly connected to cold plates in the cabinets 90, so as to directly provide the cooling liquid to key components such as CPUs and GPUs and the like without need for heat exchange of the cooling liquid in the two circulation paths through the cooling distribution unit 33. In some other embodiments, the liquid cooling portion 3 may include a plurality of cooling distribution units 33 and a plurality of cooling liquid circulation paths so as to perform a greater number of heat exchange, which is not limited by the embodiments of the present disclosure.

In some embodiments, instead of the cold plate cooling solution, the liquid cooling portion 3 may also adopt an immersion cooling solution or another type of liquid cooling solution, which is not strictly limited by the embodiments of the present disclosure.

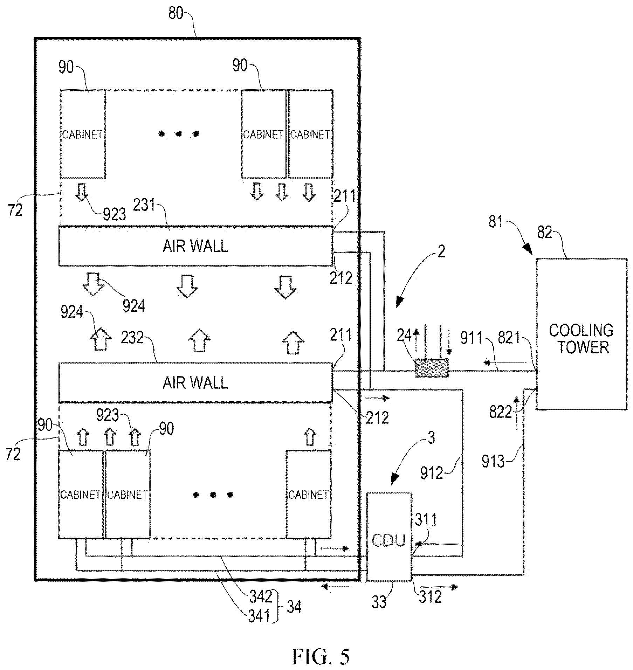

The cooling system shown in FIG. 5 has a similar structure as the cooling system shown in FIG. 4, and the differences between the two are described in detail herein, and will not be repeated for the same part.

In some embodiments, as shown in FIG. 5, two rows of cabinets 90 are disposed in the room cold pool 80. Correspondingly, an air cooling portion 2 includes a first air cooling portion and a second air cooling portion. The first air cooling portion includes a first air wall 231 for cooling a row of cabinets 90 (such as the upper row of cabinets 90 shown in FIG. 5) of the two rows of cabinets 90. The first air cooling portion is provided with a first liquid inlet 211 and a first liquid outlet 212 as described above. The first liquid inlet 211 of the first air cooling portion is connected to the first pipeline 911. The first liquid outlet 212 of the first air cooling portion is connected to the second pipeline 912. The second air cooling portion includes a second air wall 231 for cooling another row of cabinets 90 (such as the lower row of cabinets 90 shown in FIG. 5) of the two rows of cabinets 90. The second air cooling portion is also provided with a first liquid inlet 211 and a first liquid outlet 212 as described above. The first liquid inlet 211 of the second air cooling portion is connected to the first pipeline 911. The first liquid outlet 212 of the second air cooling portion is connected to the second pipeline 912.

As shown in FIG. 5, a closed hot channel 72 is formed between the upper row of cabinets 90 and the first air wall 231, so that the gas from the upper row of cabinets 90 can be guided into the first air wall 231 through the closed hot channel 72. Similarly, a closed hot channel 72 is also formed between the lower row of cabinets 90 and the second air wall 232, so that the gas from the lower row of cabinets 90 can be guided into the second air wall 232 through the closed hot channel 72. The first air wall 231 and the second air wall 232 may further be provided with a fan for driving air in the corresponding cabinets 90 to flow to the first air wall 231 and the second air wall 232 in the direction indicated by the third arrow 923, so that hot air from the cabinets 90 is cooled by the heat dissipation pipes in the first air wall 231 and the second air wall 232, and the cooled air is discharged into the room cold pool 80 in the direction indicated by the fourth arrow 924.

With the exemplary arrangement shown in FIG. 5, the server devices in the upper row cabinets 90 can only be cooled by the air cooling heat dissipation solution, and the cooling energy is all provided by the first air wall 231; and the server devices in the lower row cabinets 90 can simultaneously perform air cooling heat dissipation and liquid cooling heat dissipation, and the cooling energy can be provided by both the second air wall 232 and the liquid cooling portion 3.

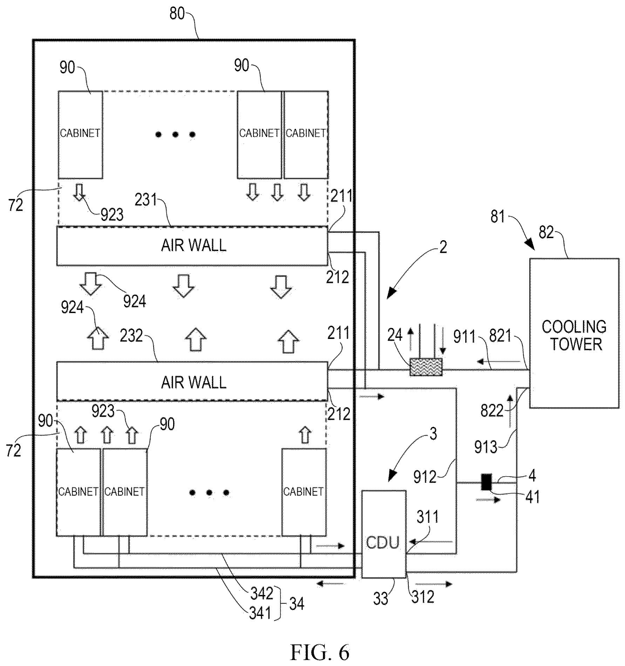

The cooling system shown in FIG. 6 has a similar structure as the cooling system shown in FIG. 5, and the differences between the two are described in detail herein, and will not be repeated for the same part.

In some cases, there may be a mismatch of cooling liquid flow between the air cooling portion 2 and the liquid cooling portion 3. For example, the air cooling portion 2 often adopts a large flow and small temperature difference design due to the low heat exchange efficiency, and the liquid cooling portion 3 often does not need to have too large cooling liquid flow. To this end, in some embodiments, a first bypass branch 4 may be provided in the cooling system to adjust the flow distribution between the air cooling portion 2 and the liquid cooling portion 3, as shown in FIG. 6. The first bypass branch 4 is connected between the second pipeline 912 and the third pipeline 913. The first bypass branch 4 is configured to guide a portion of the cooling liquid in the second pipeline 912 directly into the third pipeline 913. With this arrangement, a portion of the cooling liquid from the air cooling portion 2 may flow directly into the third pipeline 913, and then back to the cooling source 81, while another portion of the cooling liquid from the air cooling portion 2 may flow into the liquid cooling portion 3. In this way, the flow distribution between the air cooling portion 2 and the liquid cooling portion 3 can be flexibly adjusted.

In some embodiments, as shown in FIG. 6, the first bypass branch 4 includes at least one first valve 41 switchable between an open state and a closed state. When the first valve 41 is in the open state, a portion of the cooling liquid in the second pipeline 912 may flow into the third pipeline 913. When the first valve 41 is in the closed state, the cooling liquid in the second pipeline 912 all flows into the liquid cooling portion 3. It should be understood that the first valve 41 may be a valve that has only two states, the open state and the closed state, or may be a valve capable of being continuously adjusted between the open state and the closed state.

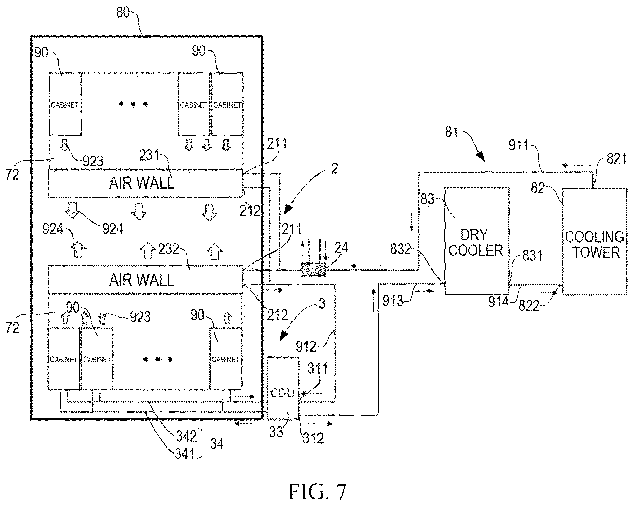

The cooling system shown in FIG. 7 has a similar structure as the cooling system shown in FIG. 5, and the differences between the two are described in detail herein, and will not be repeated for the same part.

In some embodiments, as shown in FIG. 7, the cooling source 81 includes a cooling tower 82 and a dry cooler 83. The cooling tower 82 includes a cooling tower liquid outlet 821 and a cooling tower liquid return port 822. The cooling tower liquid outlet 821 is connected to the first liquid inlet 211 via a first pipeline 911. The dry cooler 83 includes a dry cooler liquid outlet 831 and a dry cooler liquid return port 832. The dry cooler liquid return port 832 is connected to the second liquid outlet 312 via a third pipeline 913. The dry cooler liquid outlet 831 is connected to the cooling tower liquid return port 822 via a fourth pipeline 914. With this arrangement, the cooling liquid with a higher temperature returned from the liquid cooling portion 3 can first flow into the dry cooler 83 via the third pipeline 913, and the dry cooler 83 can precool the cooling liquid. Subsequently, the cooling liquid may flow out of the dry cooler 83 and flow into the cooling tower 82 for further cooling, and thus be lowered to the required temperature by the air cooling portion 2. In this way, the cooling source 81 can also perform efficient heat dissipation according to the temperature gradient, and the respective advantages of the dry cooler 83 and the cooling tower 82 are fully exerted, so that the heat dissipation efficiency of the cooling system can be further improved, and the efficiency is much higher than that of the design of the air cooling system and the liquid cooling system with completely independent external cooling source systems in the traditional data center.

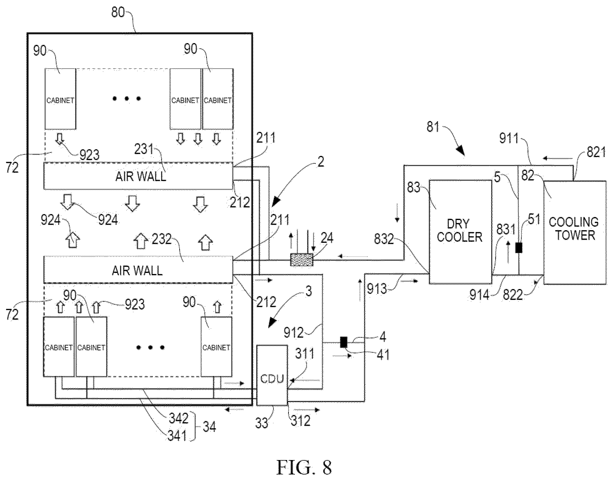

The cooling system shown in FIG. 8 has a similar structure as the cooling system shown in FIG. 7, and the differences between the two are described in detail herein, and will not be repeated for the same part.

As shown in FIG. 8, a first bypass branch 4 is provided in the cooling system for adjusting the flow distribution between the air cooling portion 2 and the liquid cooling portion 3. The first bypass branch 4 is connected between the second pipeline 912 and the third pipeline 913. The first bypass branch 4 is configured to guide a portion of the cooling liquid in the second pipeline 912 directly into the third pipeline 913. With this arrangement, a portion of the cooling liquid from the air cooling portion 2 may flow directly into the third pipeline 913, and then back to the cooling source 81, while another portion of the cooling liquid from the air cooling portion 2 may flow into the liquid cooling portion 3. In this way, the flow distribution between the air cooling portion 2 and the liquid cooling portion 3 can be flexibly adjusted.

In some embodiments, as shown in FIG. 8, the first bypass branch 4 includes at least one first valve 41 switchable between an open state and a closed state. When the first valve 41 is in the open state, a portion of the cooling liquid in the second pipeline 912 may flow into the third pipeline 913. When the first valve 41 is in the closed state, the cooling liquid in the second pipeline 912 may flow into the liquid cooling portion 3. It should be understood that the first valve 41 may be a valve that has only two states, the open state and the closed state, or may be a valve capable of being continuously adjusted between the open state and the closed state.

In addition, as shown in FIG. 8, in order to further improve the energy-saving effect of the cooling system, a second bypass branch 5 is provided between the fourth pipeline 914 and the first pipeline 911. The second bypass branch 5 is configured to guide at least a portion of the cooling liquid in the fourth pipeline 914 directly into the first pipeline 911. With this arrangement, at least a portion of the cooling liquid from the dry cooler 83 may flow directly into the first pipeline 911, while the remainder may flow into the cooling tower 821 for further cooling.

For example, in low temperature seasons, such as winter, spring, and autumn, the second bypass branch 5 may be opened such that a portion, or even all, of the cooling liquid from the dry cooler 83 flows directly into the first pipeline 911. When all the cooling liquid from the dry cooler 83 flows directly into the first pipeline 911 without flowing into the cooling tower 82, the air cooling portion 2 and the liquid cooling portion 3 can be cooled only by the dry cooler 83, which further enhances the natural cooling time of the whole cooling system, maximizes the use of the cooling source 81, makes full use of the temperature gradient of the internal heat source and the external cooling source, achieves an excellent energy-saving effect, and obtains extremely low PUE and WUE.

In some embodiments, as shown in FIG. 8, the second bypass branch 5 includes at least one second valve 51 switchable between an open state and a closed state. When the second valve 51 is in the open state, at least a portion of the cooling liquid from the dry cooler 83 may flow directly into the first pipeline 911 via the second bypass branch 5. When the second valve 51 is in the closed state, the cooling liquid from the dry cooler 83 will all flow into the cooling tower 82. It should be understood that the second valve 51 may be a valve that has only two states, the open state and the closed state, or may be a valve capable of being continuously adjusted between the open state and the closed state.

In addition, in such an embodiment, by integrating the external cooling devices of the air cooling portion 2 and the liquid cooling portion 3, the redundancy of the external cooling devices can be improved when the outdoor temperature is low, thereby improving the reliability and availability of the data center. The dry cooler 83 and the cooling tower 82 can be redundant to each other, and this arrangement is much more economical than designing redundancy for the air cooling portion 2 and the liquid cooling portion 3, respectively, which greatly reduces the initial investment of the data center.

In some embodiments, the cooling source 81 may include at least one of a water-cooled screw chiller and a water chiller in addition to the cooling tower 82 and the dry cooler 83.

In some embodiments, the first liquid outlet 212 is further connected to the cooling tower liquid return port 822 via a pipeline (not shown), the second liquid inlet 311 is further connected to the dry cooler liquid outlet 831 via a pipeline (not shown), the second pipeline 912 is provided with at least one third valve switchable between an open state and a closed state, and the fourth pipeline 914 is provided with at least one fourth valve switchable between an open state and a closed state. With this arrangement, in some cases, the cooling tower 82 may be used to provide cooling liquid for air cooling portion 2 alone, and the dry cooler 83 may be used to provide cooling liquid for liquid cooling portion 3 alone. For example, in the case where the third valve and the fourth valve are closed, the second pipeline 912 and the fourth pipeline 914 may be cut off. In this way, the cooling liquid circulation path between the air cooling portion 2 and the liquid cooling portion 3 can be cut off, and the cooling liquid circulation path between the dry cooler 83 and the cooling tower 82 can also be cut off, so that the cooling tower 82 is used to provide cooling liquid for the air cooling portion 2 alone, and the dry cooler 83 is used to provide cooling liquid for the liquid cooling portion 3 alone.

By arranging the cooling system according to the embodiments of the disclosure, the data center can be flexibly deployed to increase the flexibility of pre-planning of the data center. By means of temperature step and cooling source integration and the like, it can be realized that a high-adaptability data center solution of air cooling to liquid cooling switching, or even air cooling and liquid cooling mixed distribution under the same data center infrastructure architecture. In addition, the embodiments of the present disclosure, while having the advantages of flexible deployment and high adaptability and the like, can also fully utilize the temperature gradient of the internal heat source and the external cooling source to achieve an excellent energy-saving effect and obtain extremely low PUE and WUE.

Various embodiments of the present disclosure have been described above, which are exemplary, not exhaustive, and are not limited to the embodiments disclosed. Many modifications and variations will be apparent to those of ordinary skill in the art without departing from the scope and spirit of the illustrated embodiments. The selection of the terms used herein is intended to best explain the principles of the embodiments, practical applications, or technical improvements in the marketplace, or to enable others of ordinary skill in the art to understand the embodiments disclosed herein.

## Claims

1. A cooling system, comprising:
a cooling source (81) configured to provide a cooling liquid;
an air cooling portion (2) configured to cool an electronic device with a gas, wherein the air cooling portion (2) comprises a first liquid inlet (211) and a first liquid outlet (212), and the first liquid inlet (211) is connected to the cooling source (81) via a first pipeline (911) to receive the cooling liquid from the cooling source (81); and
a liquid cooling portion (3) configured to cool the electronic device with a liquid, wherein the liquid cooling portion (3) comprises a second liquid inlet (311) and a second liquid outlet (312), the second liquid inlet (311) is connected to the first liquid outlet (212) via a second pipeline (912) to receive the cooling liquid from the air cooling portion (2), and the second liquid outlet (312) is connected to the cooling source (81) via a third pipeline (913) to return the cooling liquid to the cooling source (81) for cooling.

2. The cooling system according to claim 1, further comprising:
a first bypass branch (4) connected between the second pipeline (912) and the third pipeline (913) and configured to guide a portion of the cooling liquid in the second pipeline (912) directly into the third pipeline (913).

3. The cooling system according to claim 2, wherein the first bypass branch (4) comprises at least one first valve (41) switchable between an open state and a closed state.

4. The cooling system according to claim 1, wherein the cooling source (81) comprises:
a cooling tower (82) comprising a cooling tower liquid outlet (821) and a cooling tower liquid return port (822), wherein the cooling tower liquid outlet (821) is connected to the first liquid inlet (211) via the first pipeline (911); and
a dry cooler (83) comprising a dry cooler liquid outlet (831) and a dry cooler liquid return port (832), wherein the dry cooler liquid return port (832) is connected to the second liquid outlet (312) via the third pipeline (913), and the dry cooler liquid outlet (831) is connected to the cooling tower liquid return port (822) via a fourth pipeline (914).

5. The cooling system according to claim 4, further comprising:
a second bypass branch (5) connected between the fourth pipeline (914) and the first pipeline (911) and configured to guide at least a portion of the cooling liquid in the fourth pipeline (914) directly into the first pipeline (911).

6. The cooling system according to claim 5, wherein the second bypass branch (5) comprises at least one second valve (51) switchable between an open state and a closed state.

7. The cooling system according to claim 4, wherein the first liquid outlet (212) is further connected to the cooling tower liquid return port (822) via a pipeline, the second liquid inlet (311) is further connected to the dry cooler liquid outlet (831) via a pipeline, the second pipeline (912) is provided with at least one third valve switchable between an open state and a closed state, and the fourth pipeline (914) is provided with at least one fourth valve switchable between an open state and a closed state.

8. The cooling system according to claim 1, wherein the cooling source (81) comprises a cooling tower (82), the cooling tower (82) comprises a cooling tower liquid outlet (821) and a cooling tower liquid return port (822), the cooling tower liquid outlet (821) is connected to the first liquid inlet (211) via the first pipeline (911), and the cooling tower liquid return port (822) is connected to the second liquid outlet (312) via the third pipeline (913).

9. The cooling system according to claim 1, wherein the air cooling portion (2) comprises:
a first air cooling portion configured to cool a first portion of the electronic device, wherein the first air cooling portion is provided with the first liquid inlet (211) and the first liquid outlet (212); and
a second air cooling portion configured to cool a second portion of the electronic device, wherein the second air cooling portion is provided with the first liquid inlet (211) and the first liquid outlet (212), and the second portion of the electronic device is further cooled by the liquid cooling portion (3).

10. The cooling system according to claim 9, wherein the first air cooling portion comprises a first air wall (231) configured to draw gas from the first portion of the electronic device, and the second air cooling portion comprises a second air wall (232) configured to draw gas from the second portion of the electronic device.

11. The cooling system according to any of claims 1 to 10, wherein the liquid cooling portion (3) further comprises:
a cooling distribution unit (33) comprising a first cooling liquid circulation path and a second cooling liquid circulation path which exchange heat with each other, wherein the first cooling liquid circulation path is connected to the second liquid inlet (311) and the second liquid outlet (312) to enable the cooling liquid to flow in the first cooling liquid circulation path, and the second cooling liquid circulation path is connected to the electronic device via a circulation pipeline (34) to provide another cooling liquid in the second cooling liquid circulation path to the electronic device.

12. The cooling system according to any one of claims 1 to 10, wherein the cooling source (81) further comprises at least one of a water-cooled screw chiller and a water chiller.
